Europäisches Patentamt

European Patent Office

Office européen des brevets

(11) Veröffentlichungsnummer: **0 492 337 A2**

# EUROPÄISCHE PATENTANMELDUNG

(21) Anmeldenummer: **91121514.3**

(22) Anmeldetag: **16.12.91**

(51) Int. Cl.5: **G11C 17/18**

(30) Priorität: **24.12.90 DE 4041959**

(43) Veröffentlichungstag der Anmeldung:
**01.07.92 Patentblatt 92/27**

(84) Benannte Vertragsstaaten:
**AT BE CH DK ES FR GB GR IT LI LU NL SE**

(71) Anmelder: **MIKROELEKTRONIK UND TECHNOLOGIE GESELLSCHAFT mbH**
**Grenzstrasse 28, PF 34**
**O-8080 Dresden(DE)**

(72) Erfinder: **Scade, Andreas, Dipl.-Phys.**
**Schützenhofstrasse 6**
**O-8023 Dresden(DE)**
Erfinder: **Aue, Axel, Dipl.-Ing.**
**Thomas-Mann-Strasse 30**
**W-7015 Korntal-Münchingen(DE)**
Erfinder: **Erler, Olaf, Dipl.-Ing.**
**Am Gorbitzbach 7/201**
**O-8028 Dresden(DE)**

(54) **Schaltungsanordnung zur Erkennung des Programmierzustandes von Durchbrennelementen.**

(57) Die Erfindung löst die Aufgabe, eine sichere Feststellung des Programmierzustandes auch bei einer erhöhten Restleitfähigkeit des programmierten Durchbrennelementes zu ermöglichen.

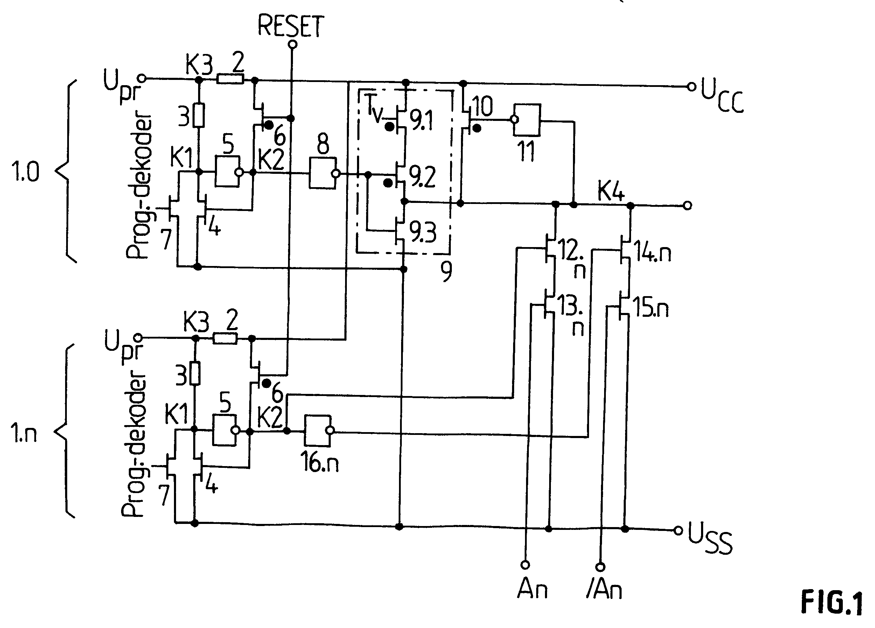

Die Schaltungsanordnung (gemäß Fig. 1) enthält einen zwischen Versorgungsspannungs- ($U_{CC}$) und Bezugspotential ($U_{SS}$) angeordneten gesteuerten Spannungsteiler aus einem Vorwiderstand (2), dem Durchbrennelement (3) und einem Entladetransistor (4). Dabei ist der Knoten zwischen dem Durchbrennelement (3) und dem Entladetransistor (4) über einen Negator (5) auf die Steuerelektrode des Entladetransistors (4) rückgeführt. Erfindungsgemäß ist zwischen dem Versorgungsspannungspotential ($U_{CC}$) und einem Ausgang des Negators (5) ein Transistor (6) angeordnet, an dessen Steuerelektrode ein Rücksetzsignal (RESET) gelegt ist, welches vorzugsweise als eine gegenüber der Einschaltfunktion der Versorgungsspannung ($U_{CC}$) zeitverzögerte Sprungfunktion realisiert ist.

Die Erfindung ist in Redundanzdekodern von Halbleiterspeichern anwendbar.

FIG.1

Die Erfindung betrifft eine Schaltungsanordnung zur Erkennung des Programmierzustandes von Durchbrennelementen nach dem Oberbegriff des Anspruches 1. Sie ist in statischen und dynamischen Halbleiterspeichern mit wahlfreiem Zugriff, welche über vermittels programmierter Durchbrennelemente zuschaltbare redundante Strukturen verfügen, einsetzbar.

Zur Ausbeuteerhöhung bei der Herstellung integrierter RAM-Speicherschaltkreise werden Redundanzstrukturen eingesetzt. Dabei handelt es sich um bewußt eingebaute Zusatzelemente, die im Bedarfsfall die Funktion defekter Elemente übernehmen.

Mit den Redundanzstrukturen lassen sich Punktdefekte korrigieren, welche in ihren Auswirkungen nur einen kleinen Teil des Speichers erfassen; also Zellausfälle, Bit- und Wortleitungsausfälle unterschiedlichen Umfanges und Kombinationen hiervon.

Da die Redundanzstrukturen nur genutzt werden, wenn Fehler auftreten, muß jedes Element über eine programmierbare Logik verfügen, welche die Zuweisung einer redundanten Struktur zur abgetrennten defekten Struktur realisiert. Dies erfolgt üblicherweise über sogenannte Redundanzdekoder.

Als Programmiertechnik hat sich dabei die Zerstörung von Leitbahnelementen, den "Durchbrennelementen", auch als "fusible links" oder "fuse" bezeichnet, mittels Laserstrahl oder elektrischer Impulse (überhöhte Leistung) allgemein durchgesetzt.

Entsprechende Lösungen sind u. a. aus der US-PS 4.047.163 bzw. aus Fitzgerald, B. F.; Thoma, E. P.: "Circuit Implementation of Fusible Redundant Adresses on RAM's for Productivity Enhancement"; IBM Journal of Research and Developement; Vol. 24 Nr. 3, pp. 291-95 bekannt.

Die Programmierung der redundanten Strukturen greift dabei auf Schaltungen zurück, welche den Programmierzustand der Durchbrennelemente erkennen bzw. bewerten.

Diesen sogenannten "Fuseerkennungsschaltungen", dargelegt u. a. in den EP-Anm. 90 332 und 120 485, ist die Bewertung der Leitfähigkeit der Durchbrennelemente gemeinsam, daß der Fusewiderstand im nichtprogrammierten Zustand wesentlich geringer ist als im programmierten. Zum sicheren Erkennen ist zwischen den beiden Zuständen ein relativ großer verbotener Widerstandsbereich festgelegt.

So verwendet die Fuseerkennungsschaltung nach EP-Anm. 290 094 einen zwischen Versorgungs- und Bezugsspannungspotential geschalteten steuerbaren Spannungsteiler aus dem Fuse und einem Entladetransistor. Dabei ist der Knoten zwischen ihnen über einen Negator auf die Steuerelektrode des Entladetransistors rückgekoppelt.

Der Ausgang des Negators führt hierbei das Signal über den Programmierzustand des Fuse und steuert gleichzeitig die Entladung des genannten Knotens.

Für eine elektrische Programmierung ist dem Entladetransistor noch ein Programmiertransistor parallelgeschaltet, dessen Steuerelektrode an einem Ausgang eines Programmierdekoders angeschlossen ist. Eine Programmierspannung wird an den Anschluß des Fuse gelegt.

Nach dem Programmieren können die Durchbrennelemante jedoch noch eine Restleitfähigkeit besitzen, welche durch nicht restlos entfernte Schichten hervorgerufen wird und im verbotenen Bereich liegt.

In den bekannten Fuseerkennungsschaltung kann bei einer solchen Restleitfähigkeit die Schaltschwelle der nachgeordneten Auswerteschaltung für ein nichtprogrammiertes Durchbrennelement in dem Spannungsteiler überschritten werden, so daß eine fehlerhafte Auswertung des ansonsten richtig programmierten Durchbrennelementes erfolgt.

Dementsprechend erfolgt keine Zuordnung von Redundanzstrukturen zu den defekten Adressen, so daß der betreffende Schaltkreis trotz Redundanzprogrammierung nicht fehlerfrei zu erhalten ist.

Der Erfindung liegt die Aufgabe zugrunde, eine Schaltungsanordnung zur Erkennung des Programmierzustandes von Durchbrennelementen, vorzugsweise in Redundanzdekodern, anzugeben, welche die sichere Feststellung des Programmierzustandes auch bei einer höheren Restleitfähigkeit des programmierten Durchbrennelementes ermöglicht, so daß eine Erhöhung der Ausbeute bei der Redundanzreparatur von statischen und dynamischen Halbleiterspeichern mit wahlfreiem Zugriff, welche insbesondere in CMOS-Technologie gefertigt werden, wo die Programmierung der redundanten Strukturen über Durchbrennelemente vorgenommen wird, erreicht wird.

Erfindungsgemäß wird die Aufgabe durch eine Schaltungsanordnung mit den Merkmalen des Patentanspruches 1 gelöst. Beim Einschalten der Versorgungsspannung eines Schaltkreises, welcher die erfindungsgemäße Schaltungsanordnung enthält, steigt diese aufgrund der Gesamtkapazität des Schaltkreises nur langsam auf den vollen Wert an. Nach dem Erreichen dieses Wertes und ggf. einer weiteren Zeitverzögerung erfolgt der Sprung des Rücksetzsignales.

Der Knoten am Ausgang des Negators, welcher den Ausgang der erfindungsgemäßen Schaltungsanordnung darstellt, wird über den genannten Transistor vom zweiten Leitfähigkeitstyp aufgeladen, so daß der Ausgang der Schaltungsanordnung beim Einschalten sicher den Pegel der Versorgungsspannung führt. Der Entladetransitor ist leitfähig, womit sich am Eingang des Negators ein Potential einstellt, das durch den Vorwiderstand, den Widerstand des Durchbrennelementes und den Widerstand des offengesteuerten Entladetransistors bestimmt wird.

Bei einem nichtprogrammierten Durchbrennelement ist es so groß, daß die Spannung über dem Entladetransistor den Negator öffnet. Bei einem programmierten Durchbrennelement ist diese Spannung so gering, daß der Negator sicher nicht aufgesteuert wird.

Wird nun das Rücksetzsignal aktiv, d. h. es schaltet auf den Pegel der Versorgungsspannung um, so wird der Ausgangsknoten des Negators nicht weiter über den Transistor aufgeladen. Damit ergibt sich der Ausgangspegel des Negators aus dem Potential an seinem Eingang.

Vorteilhafte Ausgestaltungen der Erfindung ergeben sich aus den Patentansprüchen 2 bis 4. Dabei sind die Ausgestaltungsvarianten nach den Patentansprüchen 3 und 4 für eine elektrische Redundanzprogrammierung konfiguriert.

Der erfindungsgemäß eingefügte Transistor bewirkt eine sichere Vorzugslage des Negators beim Einschalten.

Der Programmierzustand der zu bewertenden Durchbrennelemente kann auch bei einer Restleitfähigkeit nach der Programmierung sicher festgestellt werden, wobei der verbleibende verbotene Widerstandsbereich um Größenordnungen geringer ist als bei den bisher bekannten Lösungen.

Die Erfindung sei nunmehr in einem Ausführungsbeispiel anhand zweier Zeichnungen näher erläutert.

Dabei zeigen:

Fig. 1 einen Redundanzdekoder mit der erfindungsgemäßen Schaltungsanordnung für das Hauptdurchbrennelement und ein Adreßdurchbrennelement

Fig. 2 den zeitlichen Verlauf des Rücksetzsignales.

In Fig. 1 ist ein Redundanzdekoder mit einer Schaltungsanordnung 1.0 zur Erkennung des Programmierzustandes des Hauptdurchbrennelementes und einer solchen Schaltungsanordnung 1.n für ein Adreßdurchbrennelement, welche gleich aufgebaut sind, dargestellt.

Die Schaltungsanordnungen 1.0 bzw. 1.n enthalten jeweils eine Reihenschaltung aus einem Vorwiderstand 2, dem Durchbrennelement 3 und einem nMOS-Entladetransistor 4, die zwischen einem Versorgungsspannungspotential $U_{CC}$ und einem Bezugspotential $U_{SS}$ angeordnet sind. Ein Knoten K1 zwischen dem Durchbrennelement 3 und dem Entladetransistor 4 ist mit dem Eingang eines Negators 5 verbunden, dessen Ausgang als ein Knoten K2 den Ausgang der Schaltunganordnung 1.0 bzw. 1.n darstellt. Gleichzeitig ist der Ausgang des Negators 5 auf die Steuerelektrode des Entladetransistors 4 geführt.

Zwischen dem Versorgungsspannungspotential $U_{CC}$ und dem Knoten K2 ist ein pMOS-Transistor 6 geschaltet, an dessen Steuerelektrode ein Rücksetzsignal RESET gelegt ist.

Das Rücksetzsignal RESET wird in einer nicht dargestellten Schaltung beim Einschalten der Versorgungsspannung des Schaltkreises generiert. Es ist als eine gegenüber der Einschaltfunktion der Versorgungsspannung zeitverzögerte Sprungfunktion realisiert.

Beim Einschalten der Versorgungsspannung steigt diese aufgrund der hohen Gesamtkapazität des Schaltkreises nur langsam auf den endgültigen Wert an. Das Rücksetzsignal RESET schaltet nun erst nach Erreichen dieses endgültigen Wertes und einer weiteren Verzögerungszeit sprunghaft von Low-($U_{SS}$) auf High-Pegel ($U_{CC}$) um. Die gesamte Zeitverzögerung ist dabei so groß gewählt, daß das Rücksetzsignal RESET erst aktiv wird, wenn die Versorgungsspannung im Innern des Schaltkreises sicher den Wert von $U_{CC}$ führt.

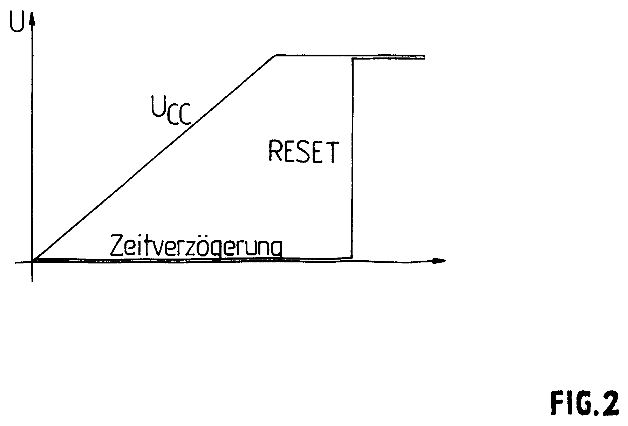

Der zeitliche Verlauf des Rücksetzsignales RESET ist noch einmal in Fig. 2 gezeigt.

Für eine elektrische Redundanzprogrammierung, d. h. das Programmieren der Durchbrennelemente 4, ist am Knoten K1 der Schaltungsanordnungen 1.0 bzw. 1.n ein Programmiertransistor 7 gegen das Bezugspotential $U_{SS}$, also parallel zum Entladetransistor 4, geschaltet. Die Steuerelektrode des Programmiertransistors 7 ist an einem zugehörigen Ausgang eines Programmierdekoders, welcher nicht dargestellt ist, angeschlossen.

Weiterhin ist am Knoten K3 zwischen dem Vorwiderstand 2 und dem Durchbrennelement 3 ein Anschluß für eine Programmierspannung $U_{pr}$ vorgesehen. Der Vorwiderstand 2 übernimmt dabei die Entkopplung vom Versorgungsspannungspotential $U_{CC}$ und dem Potential der Programmierspannung $U_{pr}$.

Der Knoten K2 der Schaltungsanordnung 1.0 ist über einen Negator 8 auf den Eingang eines getakteten Negators 9 geführt. Dieser besteht aus einer Reihenschaltung zweier pMOS-Transistoren 9.1; 9.2 und eines nMOS-Transistors 9.3, welche zwischen dem Betriebsspannungspotential $U_{CC}$ und dem Bezugspotential $U_{SS}$ angeordnet sind. Dabei bilden die miteinander verbundenen Steuerelektroden der Transistoren 9.2; 9.3 den Eingang des Negators 9; an die Steuerelektrode des Transistors 9.1 ist ein Vorladetakt $T_V$ gelegt. Der Ausgang des Negators 9 ist als Knoten K4 angegeben und stellt den Ausgang des Redundanzdekoders zu einer redundanten Adresse dar. Zwischen dem Versorgungsspannungspotential $U_{CC}$ und dem Knoten K4 ist ein pMOS-Transistor 10 geschaltet. Seine Steuerelektrode ist, geführt über einen Negator 11, am Knoten K4 angeschlossen. Der Transistor 10 dient zum aktiven Halten des High-Pegels nach dem Aufladen des Knotens K4 über den Vorladetakt $T_V$.

Zwischen dem Knoten K4 und dem Bezugspotential $U_{SS}$ sind 2n Reihenschaltungen zu je zwei nMOS-Transistoren 12.n; 13.n bzw. 14.n; 15.n angeordnet.

Dabei sind an die Steuerelektroden der Transistoren 12.n die Knoten K2 als Ausgänge der Schaltungsanordnungen 1.n und an die Steuerelektroden der Transistoren 14.n ebenfalls die zugehörigen Knoten K2, jedoch jeweils über einen Negator 16.n, gelegt.

Auf die Steuerelektroden der Transistoren 13.n sind die wahren Adressen An und auf die Steuerelektroden der Transistoren 15.n die negierten Adressen /An geführt.

Nur bei einer bestimmten Adreßkombination der Adressen An; /An wird der Knoten K4 des Redundanzdekoders nicht entladen und es kann die Auswertung des Knotens K4 im Redundanzdekoder in der beschriebenen Art und Weise erfolgen.

**Patentansprüche**

1. Schaltungsanordnung zur Erkennung des Programmierzustandes von Durchbrennelementen, vorzugsweise in CMOS-Redundanzdekodern, mit einem zwischen einem Versorgungsspannungspotential und einem Bezugspotential angeordneten gesteuerten Spannungsteiler aus der Reihenschaltung eines Vorwiderstandes, des Durchbrennelementes und eines Entladetransistors von einem ersten Leitfähigkeitstyp, wobei der Knoten zwischen dem Durchbrennelement und dem Entladetransistor über einen Negator auf die Steuerelektrode des Entladetransistors rückgeführt ist, dadurch gekennzeichnet, daß zwischen dem Versorgungsspannungspotential ($U_{CC}$) und einem Ausgang des Negators (5) ein Transistor (6) eines zweiten Leitfähigkeitstyps angeordnet und daß an dessen Steuerelektrode ein Rücksetzsignal (RESET) gelegt ist.

2. Schaltungsanordnung nach Anspruch 1, dadurch gekennzeichnet, daß das Rücksetzsignal (RESET) als eine gegenüber der Einschaltfunktion der Versorgungsspannung zeitverzögerte Sprungfunktion realisiert ist.

3. Schaltungsanordnung nach Anspruch 1 und 2, dadurch gekennzeichnet, daß am Eingang des Negators (5) ein Programmiertransistor (7) vom ersten Leitfähigkeitstyp gegen das Bezugspotential ($U_{SS}$) geschaltet ist, dessen Steuerelektrode an einem Ausgang eines Programmierdekoders angeschlossen ist.

4. Schaltungsanordnung nach Anspruch 3, dadurch gekennzeichnet, daß am Knoten zwischen dem Vorwiderstand (2) und dem Durchbrennelement (3) ein Anschluß für eine Programmierspannung ($U_{pr}$) vorgesehen ist.

FIG.1

FIG.2